# EUROPEAN PATENT APPLICATION

(11) **EP 4 632 819 A1**
(43) Date of publication of application: **15.10.2025**
(21) Application number: 24169272.2
(22) Date of filing: 09.04.2024
(51) Int. Cl.: H01L 29/06, H01L 29/40, H01L 29/78, H01L 29/417

(54) **A SEMICONDUCTOR DEVICE AND A METAL OXIDE SEMICONDUCTOR FIELD EFFECT TRANSISTOR IMPLEMENTING SUCH SEMICONDUCTOR DEVICE**

(71) Applicant: Nexperia B.V., 6534 AB Nijmegen (NL)
(72) Inventor: Pandey, Deepak Chandra, Manchester (GB); Peake, Steven, Manchester SK7 5BJ (GB)
(74) Representative: Pjanovic, Ilija

(57) **Abstract**

The present disclosure relates to a semiconductor device, especially for a metal oxide semiconductor field effect transistor, MOSFET, said semiconductor device have RESURF architecture suitable for current switching and signal processing purposes. The advantage of the disclosure is providing a semiconductor cell, especially for a metal oxide semiconductor field effect transistor, MOSFET with a lower specific on-state resistance and a higher BVdss. Also, very low specific on-state resistances can be achieved with wide cell pitches (1.6µm, for Wd=0.40µm), which improves the dynamic performance and the SOA (safe operating area) capability. The present disclosure also relates to a metal oxide semiconductor field effect transistor, MOSFET, comprising at least two semiconductor cells connected to each other.

## Description

### TECHNICAL FIELD

The present disclosure relates to a semiconductor device, especially for a metal oxide semiconductor field effect transistor, MOSFET, said semiconductor device have RESURF architecture suitable for current switching and signal processing purposes.

### BACKGROUND OF THE DISCLOSURE

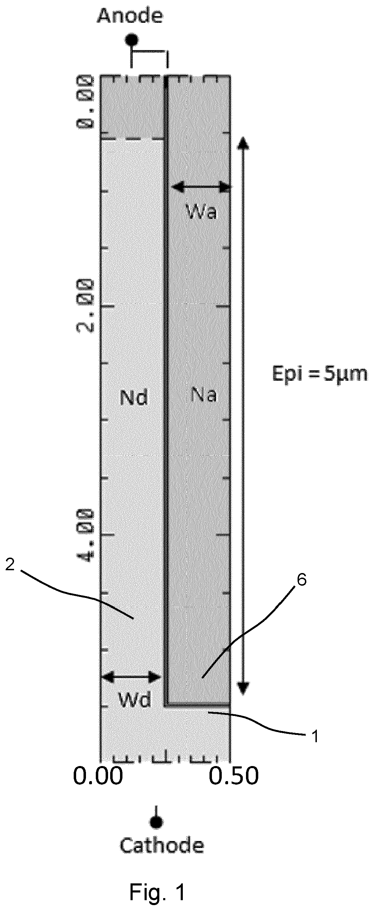

The use of a thin film dielectric (oxide in this case), where the relative permittivity of the thin film enhances the RESURF (Reduced Surface Field), is known and is used so that a lower specific on-state resistance can be achieved for the same BVdss (drain to source breakdown voltage). Super junction diodes with the thin film isolation having a RESURF area are known. Figure 1 shows simulation results for a super junction diode, where the p-type pillar is encapsulated with a thin film oxide layer, ranging in the thickness from 5nm to 250nm. An enhanced RESURF can be achieved for a thin film thickness ranging from 20nm to 200nm. One other viable option is to use a dielectric layer with a higher dielectric constant such as HfO₂ (hafnium dioxide) which is 4 to 6 times greater than that of SiO₂.

Document US7294886B2 discloses a planar DMOS technology with an insulating film separating the p and n-type RESURF regions. The insulating film is deposited in a very narrow trench with no other layers present, and the p and n-type RESURF regions are subsequently created by ion implantation. Disclosed is a power semiconductor device, including a first semiconductor layer of a first conductivity type, a second semiconductor layer of the first conductivity type and a third semiconductor layer of a second conductivity type which are alternately and laterally arranged on the first semiconductor layer and, a fourth semiconductor layer of the second conductivity type selectively formed in the surface regions of the second and third semiconductor layers, a fifth semiconductor layer of the first conductivity type selectively formed in the surface region of the fourth semiconductor layer, and a control electrode formed on the surfaces of the second, fourth and fifth semiconductor layers.

This configuration has a disadvantage of a wide n-type mesa (drift region) and a narrow p-type region forming an imbalance between the two widths will result in a lower specific Rdson for the same BVdss as the p and n-type doping concentrations can not be made to aggressive.

Document US2020098857A1 discloses a narrow mesa (a mesa is the source region of a trench power MOSFET transistor between trench gates) super junction MOSFET where the p and n-type pillars are separated by an isolation structure composed within a trench. The isolation structure can include an airgap (or gas at atmospheric or sub-atmospheric pressures) encapsulated by oxide with the top of the trench sealed with an oxide plug. The disclosed transistor device includes a n-doped pillar and a p-doped pillar forming a super-junction structure on a substrate. An isolation structure is disposed in a trench between the n-doped pillar and the p-doped pillar, and a source and a gate are disposed on the n-doped pillar. The isolation structure can include an epi liner disposed on surfaces of the n-doped pillar and the p-doped pillar. Disclosed element has oxide insulation layer between pillars width over 500 um.

Document US9425306B2 discloses a super junction trench power MOSFET (metal oxide semiconductor field effect transistor) device, a column of p-type dopant in the super junction is separated from a first column of n-type dopant by a first column of oxide and from a second column of n-type dopant by a second column of oxide. In a n-channel device, a gate element for the FET is advantageously situated over the column of p-type dopant; and in a p-channel device, a gate element for the FET is advantageously situated over the column of n-type dopant. Disclosed structure has p-type pillars under the gate network and not in the central portion of the n-type MESA. This, ultimately, will limit the achievable specific Rdson for the same BVdss as described in this prior art document.

For the above mentioned prior art document, the enhanced RESURF is achieved via the capacitive charge balancing between two deep p-type pillars (super junction concept).

Accordingly, it is a goal of the present disclosure to provide an improved semiconductor device, especially for a metal oxide semiconductor field effect transistor, MOSFET, having a RESURF architecture suitable for current switching and signal processing purposes.

### SUMMARY OF THE DISCLOSURE

According to a first example of the disclosure, a semiconductor cell, especially for a metal oxide semiconductor field effect transistor, MOSFET, device, is proposed, which has at least a gate terminal and a source terminal and comprises at least two half-cells which each comprises a substrate. Furthermore the cell comprises an EPI layer deposited on the substrate and at least one EPI pillar extending vertically from the EPI layer and extending in the first longitudinal direction, perpendicular to said vertical direction, between a first source trench on a first side of the EPI pillar and a second source trench on a second side of the EPI pillar, wherein the EPI pillar forms a drift region. The half-cell comprises a first source pillar of p-type material, deposited in the first source trench and having a thin film oxide layer isolating the first source pillar from the EPI pillar along the first longitudinal direction on the first side of the EPI pillar.

The half-cell further comprises a second source pillar of p-type material, deposited in the second source trench and having a thin film oxide layer isolating the second source pillar from the EPI pillar along the first longitudinal direction on the second side of the EPI pillar. The gate terminal is located above the first source pillar and insulated by an oxide layer from the first source pillar and from the EPI pillar. Additionally the source terminal is located above the second pillar wherein two half-cells are connected layer by layer wherein the first half-cell is arranged symmetrically to the second half-cell by a mirror reflection with respect to a mirror plane comprising the first longitudinal direction and the vertical direction, along the outer edge of first source pillar.

Preferably the bottom part of the first source pillar of p-type material deposited in the first source trench is electrically connected to the EPI layer forming a junction along a second longitudinal direction, perpendicular to said vertical direction and said first longitudinal direction.

Preferably the bottom part of the second source pillar of p-type material deposited in the second source trench is electrically connected to the EPI layer forming a junction along the second longitudinal direction.

Preferably the bottom part of the first source pillar of p-type material deposited in the first source trench is electrically insulated from the EPI layer by an additional thin film oxide layer along the second longitudinal direction.

Preferably the bottom part of the second source pillar of p-type material deposited in the second source trench is electrically insulated from the EPI layer by an additional thin film oxide layer along the second longitudinal direction.

Preferably the thin film oxide layer has thickness in the range from 10nm to 600nm preferably in the range from 20nm to 200nm.

Preferably the first pillar and/or the second pillar have a width, measured in the second longitudinal direction, in the range from 0.1µm to 0.6µm, and have a depth, measured in the vertical direction, in range from 1 µm to 3 µm.

Preferably the first pillar and/or the EPI pillar have a width, measured in the second longitudinal direction, in the range from 2 µm to 4 µm and have a depth, measured in the first longitudinal direction, in the range from 1 µm to 4 µm.

Preferably the oxide layers are made from a material having the dielectric constant at least two times higher than SiO₂, preferably four times higher than SiO₂, such as HfO₂, hafnium dioxide.

According to a second example of the disclosure, a metal oxide semiconductor field effect transistor, MOSFET, is proposed, comprising at least two semiconductor cells connected to each other.

Preferably a semiconductor field effect transistor, MOSFET, comprising a plurality of semiconductor cells connected to each other and arranged on the plane comprising first and second longitudinal direction axis in the square layout.

Preferably the metal oxide semiconductor field effect transistor, MOSFET, comprises a plurality of semiconductor cells connected to each other and arranged on the plane comprising the first and the second longitudinal direction axis in an off-setsquare layout.

Preferably the metal oxide semiconductor field effect transistor, MOSFET, comprises a plurality of semiconductor cells connected to each other and arranged on the plane comprising the first and the second longitudinal direction axis in a stripe layout.

The advantage of the disclosure is providing a semiconductor cell, especially for a metal oxide semiconductor field effect transistor, MOSFET with a lower specific on-state resistance and a higher BVdss. Also, very low specific on-state resistances can be achieved with wide cell pitches (1.6µm, for Wd=0.40µm), which improves the dynamic performance and the SOA (safe operating area) capability.

According to an example of the disclosure, the semiconductor cell advantageously has a lower Rds(on) (on state resistance) for the same BVdss (breakdown voltage) through enhanced RESURF and a well-defined super junction p-type pillars which are created by p-type polysilicon of silicon deposition. Alternatively this can be achieved via p-type epi growth. Thin film oxide layers are grown in a trench in order to enhance the RESURF change balancing concept and to define the width and the depth of the super junction p-type pillars.

### BRIEF DESCRIPTION OF THE DRAWINGS

The disclosure will now be discussed with reference to the drawings, which show in:
- Figure 1: a cross section of a diode element.
- Figure 2A: a cross section of half-cell element having the Na pillars isolated from the EPI layer
- Figure 2B: a cross section of half-cell element having the bottom part of the Na pillars being not isolated forming a junction with the EPI layer.
- Figure 3: a cross section of cell (whole-cell) element having the Na pillars isolated from the EPI layer.
- Figure 4: a cross section of cell (whole-cell) element having the bottom part of the Na pillars not isolated forming the junction with the EPI layer and having the isolating layer in the vertical direction.
- Figure 5A: a top view of the semiconductor element comprising many semiconductor cells (whole-cells) arranged in hexagonal layout.
- Figure 5B: a top view of the semiconductor element comprising a plurality semiconductor cells (whole-cells) arranged in a square layout.
- Figure 5C: a top view of the semiconductor element comprising a plurality semiconductor cells (whole-cells) arranged in an off-set square layout.
- Figure 5D: a top view of the semiconductor element comprising a plurality semiconductor cells (whole-cells) arranged in a stripe layout.

### DETAILED DESCRIPTION OF THE DISCLOSURE

For a proper understanding of the disclosure, in the detailed description below corresponding elements or parts of the disclosure will be denoted with identical reference numerals in the drawings. For expediency, all simulations mentioned have been undertaken using the MEDICI 2D device simulator and all breakdown voltages (BVdss) have been done for a drain current of 1mA with all carriers and ionization models initialized.

Figure 1 depicts a known concept of use of a thin film dielectric (oxide in this case) in a diode element, where the relative permittivity of the thin film enhances the RESURF, so that a lower specific on-state resistance can be achieved for the same BVdss (drain to source breakdown voltage). The enhanced RESURF is achieved via the capacitive charge balancing between two deep p-type pillars (super junction concept).

Figure 1 shows a super junction diode with enhanced RESURF using a thin film (oxide) dielectric. For better understanding and clarity a list of commonly used acronyms is proposed below.
- Na: = Acceptor (p-type) concentration
- Nd: = Donor (n-type) concentration
- Wa: = Width of the super junction acceptor p-type pillar
- Wd: = Width of the donor drift region

The thin film oxide (6a, 6b) dielectric is the thin region between pillars (4, 5, 11, 12,) and the EPI layer.

In Figure 1 a super junction diode is shown, wherein the p-type pillar is encapsulated with a thin film oxide layer (6), ranging in thickness from 5nm to 250nm. For the same (or increased) BVdss, a higher donor (Nd) can be used - this will translate into a lower specific on-state resistance. An enhanced RESURF can be achieved for a thin film thickness ranging from 20nm to 200nm. In Figure 1, an oxide dielectric has been used and the best performance is achieved for very thin films (< 30nm). However, concerns over the dielectric field strength for oxide (15MV/cm (or 1.5V/nm) at room temperature), will limit the workable thin film oxide thickness. One other viable option is to use a dielectric layer with a higher dielectric constant such as HfO₂ (hafnium dioxide) which is four to six times greater than that of SiO₂.

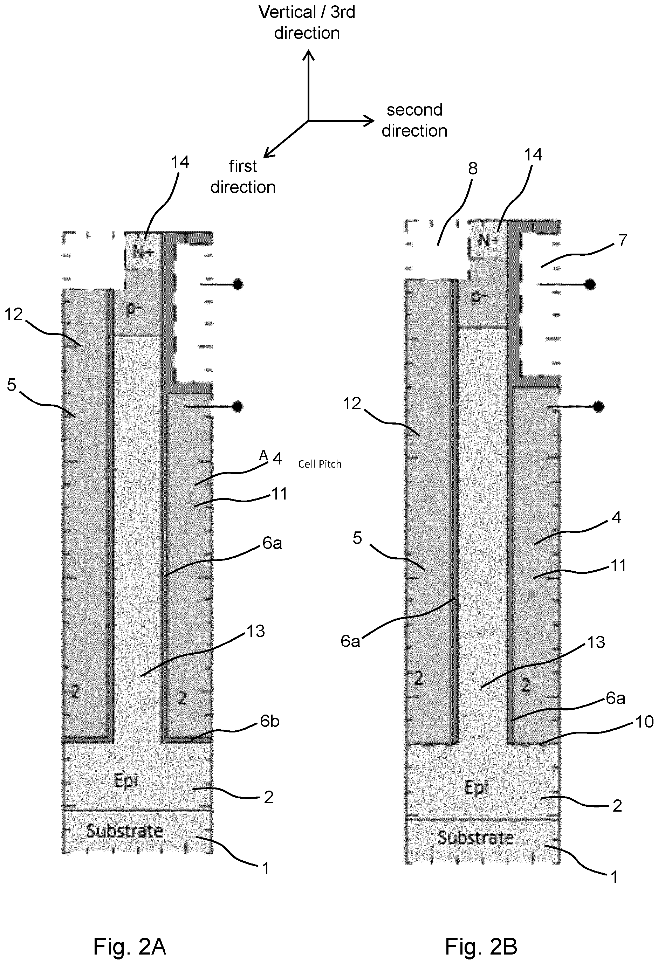

In Figure 2A and Figure 2B a trench MOSFET cell is presented. In Figure 2A p-type pillars (4, 5, 11,12) are completely encapsulated by the EPI layer (2) and the EPI pillar (13), and the oxide layer is oriented vertically (6b) and horizontally (6a). Where in the description there is reference to a direction, vertically means third longitudinal and horizontally means second longitudinal direction according to the graph of Figure 2.

In Figure 2B p-type pillars (4, 5, 11,12) are only encapsulated vertically (by means of oxide layer 6b) and there is no thin film at the bottom of the p-type pillar. The RHS (Rectangular Hollow Section) schematically shows the whole cell for configuration, the initial simulations were made for a Trench MOSFET with a Vds (drain to source voltage) rating of 40V. Advantageously, Vds was scaled to 60V also. Configurations from Figure 2A wherein the p-type pillars (4, 5, 11,12) (Na, Wa) are totally encapsulated by a 20nm thin film oxide layer and there is no junction between the p-type (4, 5, 11,12) (Na) and drift (Nd) regions locate in the EPI pillar (13). Configuration from figure 2B wherein the 20nm thin file oxide layer has been removed (on not deposited) from the base (bottom) of the p-type pillars (4, 5, 11,12) regions. There is now a junction (1) between Na the p-type pillars (4, 5, 11,12) and Nd drift (Nd) regions located in the EPI layer (2) at this point. The 20nm thin film oxide layer (6a) separates the p-type pillars (4, 5, 11,12) (Na) and the (Nd) regions located in the EPI pillar (13). The width of the pillars is 0.4µm - including the thin film oxide layer.

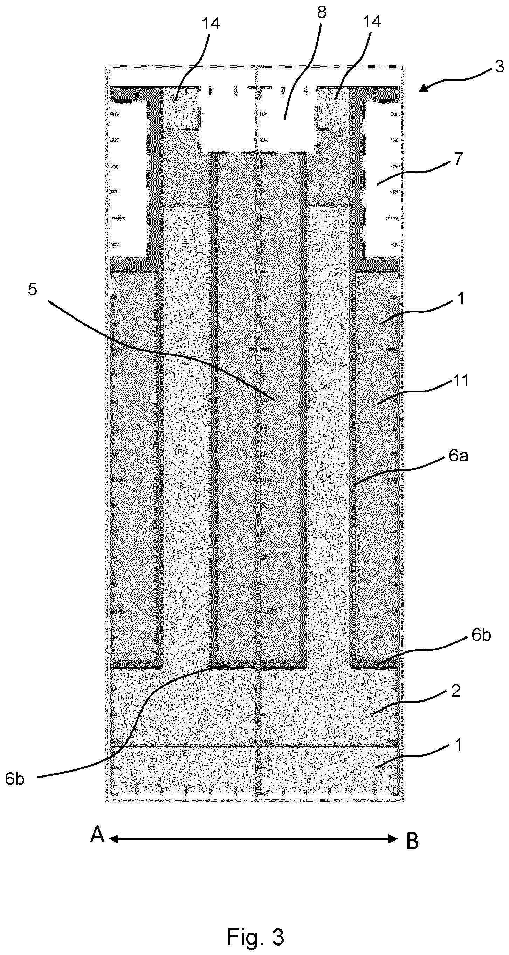

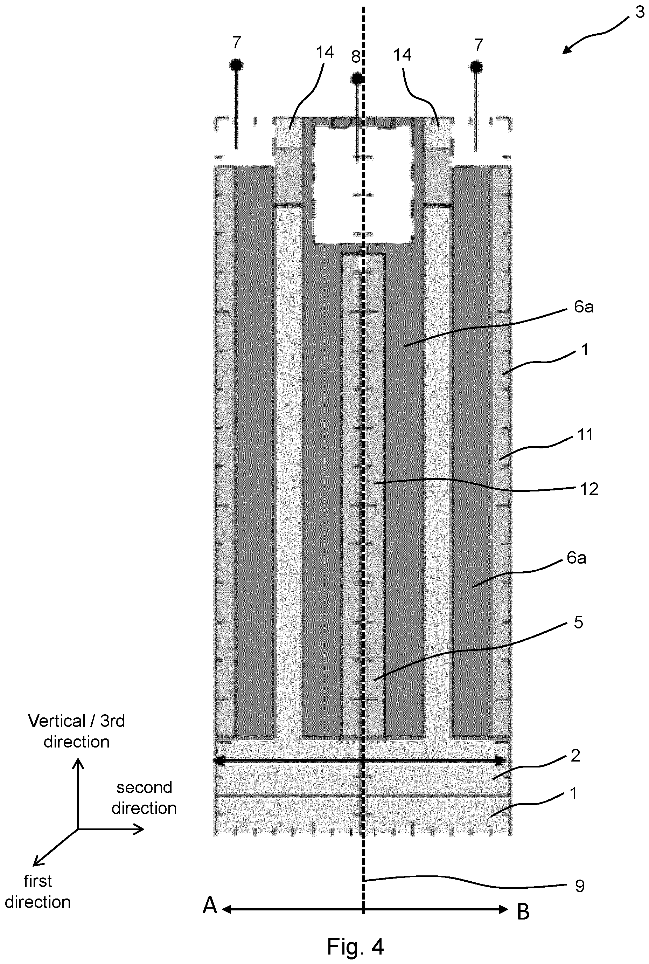

In Figures 2A and 2B there are two examples of the half-cell illustrated, a cell is constructed by mirroring the half-cell unit (Figure 3 and Figure 4).

In Figure 2B, according to the first example of the disclosure, a half-cell is shown, comprising a substrate (1) and an EPI layer (2) deposited on the substrate (1). However, as an alternative it can also be formed as one element and subsequently cut or manufactured in this manner by any means. Seen from the EPI layer (2), a EPI pillar (13) is extending vertically (with reverence to a cross section) from the EPI layer (2) and extending in the first longitudinal direction, perpendicular to the vertical direction (in a real 3D cell). The EPI pillar (13) is located between a first source trench (11) on a first side of the EPI pillar (13) and a second source trench (12) on a second side of the EPI pillar (13). The EPI pillar (13) forms a drift region while the cell is operating under voltage.

The cell also comprises a first source pillar (4) of p-type material, deposited in the first source trench (11). The source pillar (4) has a thin film oxide layer (6a) isolating the first source pillar (4) from the EPI pillar (13) along the first longitudinal direction on the first side of the EPI pillar (13). The cell further comprises a second source pillar (5) of p-type material, deposited in the second source trench (12) and having a thin film oxide layer (6a) isolating the second source pillar (5) from the EPI pillar (13) along the first longitudinal direction on the second side of the EPI pillar (13).

In the cell, the gate terminal (7) is located above the first source pillar (4) and insulated by an oxide layer (6) from the first source pillar (4) and from the EPI pillar (13). Furthermore, the source terminal (8) is located above the second pillar (5). Two half-cells form one cell, precisely two half-cells are connected layer by layer. Accordingly, there is no physical barrier, and in the example the whole cell can be manufactured this way as one unit. Note that the term 'half-cell' refers to one part of the symmetric cell and this term is used only for making the description more clear.

The whole-cell (cell) is arranged such that the first half-cell is arranged symmetrically to the second half-cell by a mirror reflection with respect to a mirror plane (9) comprising the first longitudinal direction and the vertical direction, along the outer edge of first source pillar (4).

In Figure 2A the bottom part of the second source pillar (5) of p-type material deposited in the second source trench (12) is electrically insulated from the EPI layer (2) by an additional thin film oxide layer (6b) along the second longitudinal direction. There is no junction in this region. The thin film oxide layer (6a, 6b) has a thickness of 20nm.

In Figure 3 a semiconductor cell for a metal oxide semiconductor field effect transistor, MOSFET, is shown. The cell is arranged with two half-cells of the configuration shown in Figure 2A, with the bottom part of the second source pillar (5) of p-type material deposited in the second source trench (12) being electrically insulated from the EPI layer (2) by an additional thin film oxide layer (6b) along the second longitudinal direction. There is no junction in this region. The thin film oxide layer (6a, 6b) has a thickness in the range from 20nm.

In Figure 4 a semiconductor cell for a metal oxide semiconductor field effect transistor, MOSFET, is shown. This example of the cell is arranged with two half-cells of the configuration shown in Figure 2B, without the bottom part of the second source pillar (5) of p-type material deposited in the second source trench (12) being electrically connected from the EPI layer (2) due to the absence of the additional thin film oxide layer (6b) along the second longitudinal direction. Therefor, in Figure 4 a junction (9) is present in this region. The thin film oxide layer (6a) has a thickness large of about 80nm.

Initial simulations have been carried out for a 20nm thin film oxide thickness and the Figure 2B configuration has been used. All specific on-state resistance simulations shown are without substrate contribution and at Vgs=10V. Further simulations have been carried out for increasing thin film oxide thicknesses ranging from 40nm to 150nm to determine the impact upon the specific on-state resistance.

As this is a device 2D simulation and not a process simulation, there are no process schematics to show the process route. All regions (depths, Wd, Wa etc.) and concentrations (Na, Nd) have been defined by code in the script. It is anticipated that the p-type pillars would be created by either a polysilicon or silicon deposition or by epi growth post thin film dielectric (SiO₂ or HfO₂) growth. Using a thin film dielectric layer to separate the two RESURF regions, enables very well-defined widths and reduces the p-type pillar depletion into the drift region during the on-state; thereby, constricting the current flow.

The initial simulation has been extended in scope to include thicker, thin film oxide layer (6a, 6b) thicknesses and assess the impact upon specific on-state resistance. The thin film dielectric was a high K variant, as the increased dielectric constant enables a thinner, thin film to be used, which enables a higher donor Nd concentration to be used.

By encapsulating the p-type super junction pillars (4, 5, 11,12), the RESURF can be enhanced, and a lower specific on-state resistance can be achieved for the same BVdss. Also, very low specific on-state resistances can be achieved with wide cell pitches (1.6µm, for Wd=0.40µm), which improves the dynamic performance and the SOA capability.

The semiconductor cell of Figure 3 exhibits in the preferred example of the disclosure an operating voltage range of Vds from 25V to 800V for the P-type pillar width range (11) from 0.1µm for Vds=25V to 8µm for Wds=800V. The EPI thickness is in the range (assuming 15V/µm) from 1.7µm for Vds=25V to 55µm for Vds=800V.

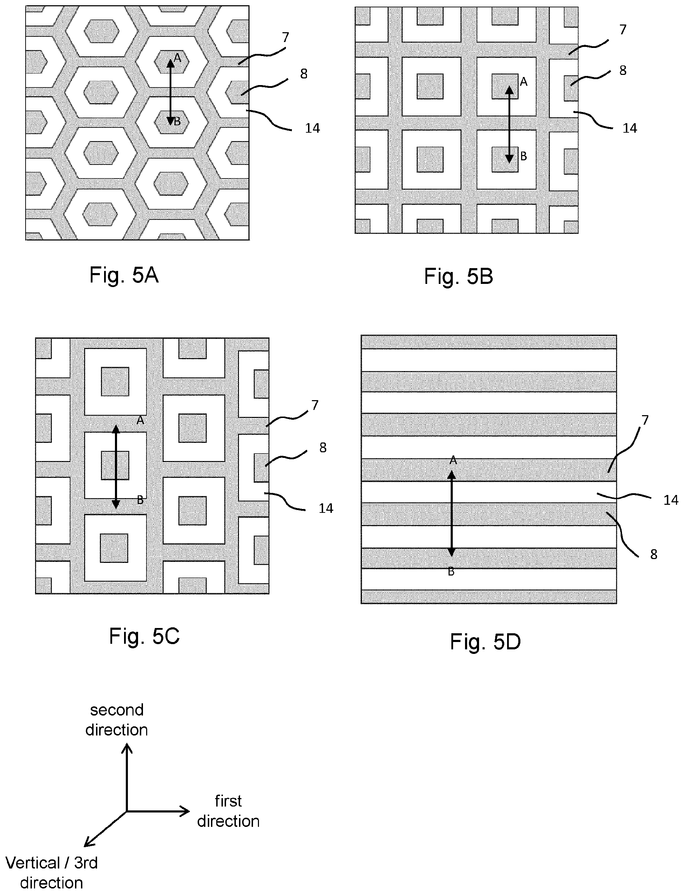

Figure 5A shows a top view of the semiconductor element comprising a plurality of semiconductor cells (whole-cells) arranged in a hexagonal layout. Each cell has a pitch, defined as the length between point A and B (in any direction) which length is equal to the whole-cell width defined as the distance from point A to B in the second longitudinal direction of a whole-cell of Figure 3 and/or of Figure 4. The pitch is a distance between the cells and it is not related to any particular direction or angle. In this example of the disclosure the cells (whole-cells) are arrange in a hexagonal layout and the pitch is defined in the second longitudinal direction.

Figure 5B shows a top view of the semiconductor element comprising a plurality of semiconductor cells (whole-cells) arranged in a square layout. Each cell has a pitch, defined as the length between point A and B (in any direction) which length is equal to the whole-cell width defined as the distance from point A to B in the second longitudinal direction of a whole-cell of Figure 3 and/or Figure 4. The pitch is a distance between the cells and it is not related to any particular directions or angle. In this example of the disclosure cells (whole-cells) are arrange in a square layout and the pitch is defined in the second longitudinal direction.

Figure 5C shows a top view of the semiconductor element comprising a plurality of semiconductor cells (whole-cells) arranged in an off-set square layout. Each cell has a pitch, defined as the length between point A and B (in any direction) which length is equal to the whole-cell width defined as the distance from point A to B in the second longitudinal direction of a whole-cell oh Figure 3 and/or of Figure 4. The pitch is a distance between the cells and it is not related to any particular direction or angle. In this example of Figure 5C the cells (whole-cells) are arranged in an off-set square layout and the pitch is defined in the second longitudinal direction.

Figure 5D shows a top view of the semiconductor element comprising a plurality of semiconductor cells (whole-cells) arranged in stripe (or parallel aligned) layout. Each cell has a pitch, defined as the length between point A and B (in any direction) which length is equal to the whole-cell width defined as distance from point A to B in the second longitudinal direction of a whole-cell of Figure 3 and/or of Figure 4. The pitch is a distance between the cells and it is not related to any particular direction or angle.

Figure 3 and Figure 4 show cross section views representing cross section of a multi cell arrangements from figures Figure 5A, Figure 5B, Figure 5C or Figure 5D along the line between point A and point B.

### LIST OF REFERENCE NUMERALS USED

- 1: substrate
- 2: EPI layer
- 3: semiconductor cell
- 4: first source pillar
- 5: second source pillar
- 6a: oxide layer
- 6b: oxide layer
- 7: gate terminal
- 8: source terminal
- 9: mirror plane
- 10: junction region
- 11: first source trench
- 12: second source trench
- 13: EPI pillar
- 14: source region

## Claims

1. A semiconductor cell, especially for a metal oxide semiconductor field effect transistor, MOSFET, device, said cell having at least a gate terminal and a source terminal and comprising at least two half-cells each comprising:
a. a substrate;
b. an EPI layer deposited on the substrate and at least one EPI pillar extending vertically from the EPI layer and extending in the first longitudinal direction, perpendicular to said vertical direction, between a first source trench on a first side of the EPI pillar and a second source trench on a second side of the EPI pillar, wherein the EPI pillar forms a drift region;
c. a first source pillar of p-type material, deposited in the first source trench and having a thin film oxide layer isolating the first source pillar from the EPI pillar along the first longitudinal direction on the first side of the EPI pillar;
d. a second source pillar of p-type material, deposited in the second source trench and having a thin film oxide layer isolating the second source pillar from the EPI pillar along the first longitudinal direction on the second side of the EPI pillar;
wherein the gate terminal is located above the first source pillar and insulated by an oxide layer from the first source pillar and from the EPI pillar; and wherein the source terminal is located above the second pillar, wherein two half-cells are connected layer by layer wherein the first half-cell is arranged symmetrically to the second half-cell by a mirror reflection with respect to a mirror plane comprising the first longitudinal direction and the vertical direction, along the outer edge of first source pillar.

2. The cell according to claim 1, wherein the bottom part of the first source pillar of p-type material deposited in the first source trench is electrically connected to the EPI layer forming a junction along a second longitudinal direction, perpendicular to said vertical direction and said first longitudinal direction.

3. The cell according to claim 1 or 2, wherein the bottom part of the second source pillar of p-type material deposited in the second source trench is electrically connected to the EPI layer forming a junction along the second longitudinal direction.

4. The cell according to claim 1, wherein the bottom part of the first source pillar of p-type material deposited in the first source trench is electrically insulated from the EPI layer by an additional thin film oxide layer along the second longitudinal direction.

5. The cell according to claim 1 or 2, wherein the bottom part of the second source pillar of p-type material deposited in the second source trench is electrically insulated from the EPI layer by an additional thin film oxide layer along the second longitudinal direction.

6. The cell according to any one of the preceding claims, wherein at least part of the thin film oxide layer has thickness in the range from 10nm to 600nm preferably in the range from 20nm to 200nm.

7. The cell according to any one of the preceding claims, wherein the first pillar and/or the second pillar have the width, measured in the second longitudinal direction, in the range from 0.1µm to 0.6µm, and have the depth, measured in the vertical direction, in range from 1 µm to 3 µm.

8. The cell according to any one of the preceding claims, wherein the first pillar and/or the EPI pillar have the width, measured in the second longitudinal direction, in the range from 2 µm to 4 µm and have the depth, measured in the first longitudinal direction, in the range from 1 µm to 4 µm.

9. The cell according to any one of preceding claims, wherein the oxide layers are made from a material having the dielectric constant at least 2 times higher than SiO₂, preferably 4 times higher than SiO₂, such as HfO₂, hafnium dioxide.

10. A metal oxide semiconductor field effect transistor, MOSFET, comprising at least two semiconductor cells according to any of claims from 1 to 9, connected to each other.

11. A metal oxide semiconductor field effect transistor, MOSFET, comprising plurality of semiconductor cells according to any of claims from 1 to 9, connected to each other and arranged on the plane comprising first and second longitudinal direction axis in the hexagonal layout.

12. A metal oxide semiconductor field effect transistor, MOSFET, comprising plurality of semiconductor cells according to any of claims from 1 to 9, connected to each other and arranged on the plane comprising first and second longitudinal direction axis in the square layout.

13. A metal oxide semiconductor field effect transistor, MOSFET, comprising plurality of semiconductor cells according to any of claims from 1 to 9, connected to each other and arranged on the plane comprising first and second longitudinal direction axis in the off-setsquare layout.

14. A metal oxide semiconductor field effect transistor, MOSFET, comprising plurality of semiconductor cells according to any of claims from 1 to 9, connected to each other and arranged on the plane comprising first and second longitudinal direction axis in the stripe layout.
